(19) Europäisches Patentamt / European Patent Office / Office européen des brevets

(11) **EP 3 800 771 B1**

(12) **EUROPEAN PATENT SPECIFICATION**

(45) Date of publication and mention
of the grant of the patent:
**20.03.2024   Bulletin 2024/12**

(21) Application number: **18923316.6**

(22) Date of filing: **22.06.2018**

(51) International Patent Classification (IPC):
**H03K 17/691** *(2006.01)*      **H02M 1/08** *(2006.01)*
**H03K 17/567** *(2006.01)*

(52) Cooperative Patent Classification (CPC):
**H03K 17/691; H03K 17/567;** H03K 2217/0036

(86) International application number:
**PCT/CN2018/092520**

(87) International publication number:
**WO 2019/242029 (26.12.2019 Gazette 2019/52)**

(54) **ISOLATION DRIVER**

ISOLIERTER TREIBER

CIRCUIT D'ATTAQUE D'ISOLATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**07.04.2021   Bulletin 2021/14**

(73) Proprietor: **HUAWEI TECHNOLOGIES CO., LTD.
Shenzhen, Guangdong 518129 (CN)**

(72) Inventors:
• **ZHU, Yu**
  **Shenzhen, Guangdong 518129 (CN)**
• **LI, Zheng**
  **Shenzhen, Guangdong 518129 (CN)**
• **WANG, Guorui**
  **Shenzhen, Guangdong 518129 (CN)**
• **WANG, Minggui**
  **Shenzhen, Guangdong 518129 (CN)**
• **HOU, Huiqi**
  **Shenzhen, Guangdong 518129 (CN)**
• **ZHANG, Zhenming**
  **Shenzhen, Guangdong 518129 (CN)**
• **CAI, Zhonghua**
  **Shenzhen, Guangdong 518129 (CN)**
• **PANG, Zhiyuan**
  **Shenzhen, Guangdong 518129 (CN)**
• **WANG, Chen**
  **Shenzhen, Guangdong 518129 (CN)**

(74) Representative: **Gill Jennings & Every LLP
The Broadgate Tower
20 Primrose Street
London EC2A 2ES (GB)**

(56) References cited:
WO-A1-2014/059620          WO-A1-2014/059620
CN-A- 106 160 427           CN-U- 201 846 225
DE-A1-102012 218 284        US-A- 4 937 470
US-A- 5 514 921             US-A- 5 514 921
US-A- 5 686 854             US-B1- 6 807 071
US-B2- 7 656 687

## Description

## TECHNICAL FIELD

This application relates to the field of digital isolation technologies, and in particular, to an isolated driver.

## BACKGROUND

A digital isolation technology is mainly used for transmission of a digital signal and a Boolean signal, to isolate noise and isolate a high voltage domain from a low voltage domain. To meet a high speed communication requirement, a high speed digital isolation technology gains extensive attention from people.

Currently, a high speed isolation communications interface is widely applied, for example, an envelope tracker, a direct current-direct current (direct current-direct current, DCDC) power module with high power density and efficiency, an inverter needing a high isolation voltage and high reliability, and highly automatic test equipment. A most important module in the high speed isolation communications interface is a high-speed high-voltage isolation module.

Currently, there are generally three types of isolated driver structures: a photoelectric coupling structure, a capacitive coupling structure, and a magnetic coupling structure. Currently, a high-speed high-voltage isolation module generally uses the magnetic coupling structure. Compared with a conventional photoelectric coupling structure, the magnetic coupling structure has a higher transmission rate, higher precision, and a higher common mode rejection capability. Among modulation schemes based on the magnetic coupling structure, pulse polarity modulation has a highest transmission rate and lowest system power consumption.

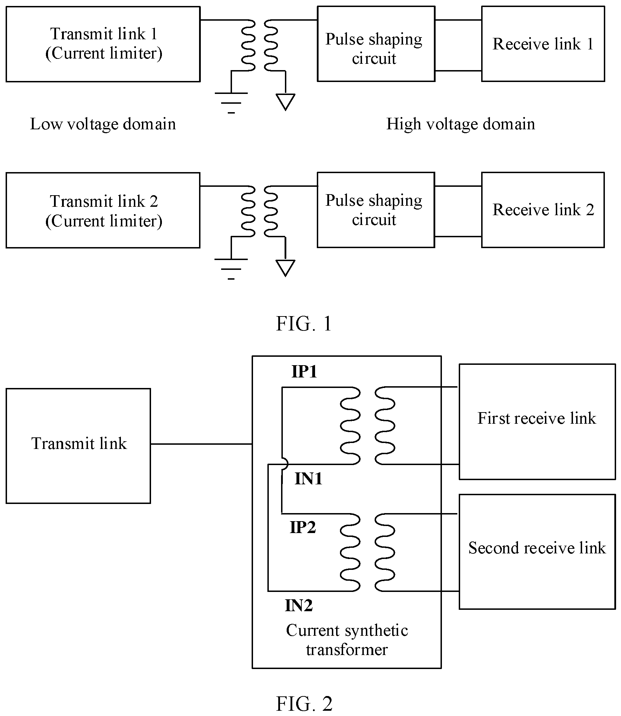

In the prior art, as shown in FIG. 1, electrical isolation between a high voltage domain and a low voltage domain is implemented by using an on-chip integrated transformer, and a signal is transmitted through magnetic coupling between primary and secondary coils of the transformer. To output a pair of differential signals, two isolated channels are used. A current limiter on a transmit link (transmit, TX) and a pulse shaping circuit on a receive link (receive, RX) are configured to shape a signal inside the transformer, to prevent false triggering caused by noise and reduce a bit error rate. It can be learned that in the prior art, two independent isolated channels are needed to implement transmission of two pulse signals, increasing power consumption and costs of a system. In addition, it is difficult to correct a delay mismatch between the independent channels, limiting an application scope of the prior art.

WO 2014/059620 relates to an isolated driving circuit comprising an isolated driving transformer, a double-end excitation signal driving and controlling circuit and a pulse-driving signal conversion circuit, wherein the double-end excitation signal driving and controlling circuit is used for generating a first pulse driving signal and a second pulse driving signal; and the pulse-driving signal conversion circuit is used for converting an output signal of a secondary winding into a driving signal which is used for driving a corresponding power switching tube. The isolated driving circuit provided by the present invention can avoid resonance oscillation caused by the magnetic inductances of a blocking capacitor and a driver transformer.

US 5514921 describes gate driver circuit, including either a full-bridge or a half-bridge configuration of gate drive switching devices, which is capable of applying gate drive signals of variable pulse widths in a substantially lossless manner to power switching devices of a high-frequency resonant switching converter, while providing transformer isolation between the gate drive electronics and the power switching devices.

## SUMMARY

Embodiments of this application provide an isolated driver, so that only one channel is needed for transmitting two pulse signals, thereby reducing power consumption and costs of a system, reducing delay matching between two output signals, and expanding an application scope of the isolated driver.

According to a first aspect, an embodiment of this application provides an isolated driver as set out in claim 1.

During implementation of this embodiment of this application, two pulse signals can be transmitted by using one transmit link. Compared with the prior art, one transmit link is saved, and power consumption and costs of the isolated driver are reduced. In addition, the pulse signal output by the transmit link is cross-input to the foregoing current composite transformer, to output the two pairs of differential signals, thereby reducing delay matching between the two pairs of differential signals, and expanding an application scope of the isolated driver.

In a possible implementation, the isolated driver further includes an impedance module, and the impedance module is configured to reduce overshoot signals of the triangular pulse signals output by the first secondary coil and the second secondary coil.

In this embodiment of this application, the impedance module may be added to adjust a quality factor (a Q value) of the composite transformer, to obtain both high pulse peak values and low overshoot peak values of the output signals of the composite transformer. The high pulse peak values help the receive links to more easily identify the output signals of the composite transformer, and the low overshoot peak values help to shape the output signals of the composite transformer, to prevent the first receive link and the second receive link from incorrectly generating pulses based on the overshoot signals when outputting the square wave pulse signals based on the output signals of the composite transformer, thereby reducing a bit error rate and improving system reliability.

In a possible embodiment, the transmit link includes a first output end, configured to output one square wave pulse signal, the positive input of the first primary coil and the positive input of the second primary coil are electrically connected to the first output end of the transmit link, and the negative input of the first primary coil and the negative input of the second primary coil are grounded.

During implementation of this embodiment of this application, the transmit link can be enabled to output one pulse signal, and the composite transformer is driven to perform magnetic coupling transmission on the pulse signal, to finally output one pair of differential signals, thereby reducing delay matching between the output differential signals.

In a possible implementation, the impedance module includes a first resistor, and the positive input of the first primary coil and the positive input of the second primary coil are electrically connected to the first output end of the transmit link by using the first resistor.

In this embodiment of this application, the impedance module includes the first resistor, and an optimal Q value of the composite transformer is obtained by adjusting a resistance value of the first resistor, to reduce the overshoot signals of the pulse signals output by the composite transformer, to prevent the first receive link and the second receive link from incorrectly generating pulses based on the overshoot signals when outputting the square wave pulse signals based on the output signals of the composite transformer, thereby reducing the bit error rate and improving the system reliability.

In a possible implementation, the impedance module further includes a first direct-current blocking capacitor, and the first resistor is electrically connected to the output end of the transmit link by using the first direct-current blocking capacitor.

In this embodiment of this application, the first direct-current blocking capacitor is further added to the impedance module, to prevent the first primary coil and the second primary coil of the composite transformer from introducing extra direct currents, thereby reducing static power consumption of the isolated driver.

In a possible implementation, the transmit link includes a first output end and a second output end, each of the first output end and the second output end is configured to output one square wave pulse signal, the square wave pulse signals output by the first output end and the second output end are differential signals of each other, the positive input of the first primary coil and the positive input of the second primary coil are electrically connected to the first output end of the transmit link, and the negative input of the first primary coil and the negative input of the second primary coil are electrically connected to the second output end of the transmit link.

During implementation of this embodiment of this application, the transmit link is enabled to output the two square wave pulse signals, and the two square wave pulse signals are cross-input to the current composite transformer to output the two pairs of differential triangular pulse signals. Because magnetic fields of the first primary coil and the second primary coil depend on both of the two square wave pulse signals, amplitude and phase self-calibration can be performed on the two square wave pulse signals inside the current composite transformer, to reduce delay matching between the output two pairs of differential triangular pulse signals, and reduce delay matching between the square wave pulse signals output by the first receive link and the second receive link.

In a possible implementation, the impedance module includes a first resistor and a second resistor, the positive input of the first primary coil and the positive input of the second primary coil are electrically connected to the first output end of the transmit link by using the first resistor, and the negative input of the first primary coil and the negative input of the second primary coil are electrically connected to the second output end of the transmit link by using the second resistor.

In this embodiment of this application, the impedance module includes the first resistor and the second resistor, and an optimal Q value of the composite transformer is obtained by adjusting resistance values of the first resistor and the second resistor, to reduce the overshoot signals of the pulse signals output by the composite transformer, to prevent the first receive link and the second receive link from incorrectly generating pulses based on the overshoot signals when outputting the square wave pulse signals based on the output signals of the composite transformer, thereby reducing the bit error rate and improving the system reliability.

In a possible implementation, the impedance module further includes a first direct-current blocking capacitor and a second direct-current blocking capacitor, the first resistor is electrically connected to the first output end of the transmit link by using the first direct-current blocking capacitor, and the second resistor is electrically connected to the second output end of the transmit link by using the second direct-current blocking capacitor.

In this embodiment of this application, the first direct-current blocking capacitor and the second direct-current blocking capacitor are further added to the impedance module, to prevent the first primary coil and the second primary coil of the composite transformer from introducing extra direct currents, thereby reducing static power consumption of the isolated driver.

In a possible implementation, the impedance module includes a first resistor, one end of the first resistor is electrically connected to the first output end of the transmit link, the positive input of the first primary coil, and the positive input of the second primary coil, and the other end of the first resistor is electrically connected to the second output end of the transmit link, the negative input of the first primary coil, and the negative input of the second primary coil.

In this embodiment of this application, the impedance module includes the first resistor, and an optimal Q value of the composite transformer is obtained by adjusting a resistance value of the first resistor, to reduce the overshoot signals of the pulse signals output by the composite transformer, to prevent the first receive link and the second receive link from incorrectly generating pulses based on the overshoot signals when outputting the square wave pulse signals based on the output signals of the composite transformer, thereby reducing the bit error rate and improving the system reliability.

In a possible implementation, the impedance module further includes a first direct-current blocking capacitor and a second direct-current blocking capacitor, the first direct-current blocking capacitor is electrically connected to the first output end of the transmit link and one end of the first resistor, and the second direct-current blocking capacitor is electrically connected to the second output end of the transmit link and the other end of the first resistor.

In this embodiment of this application, the first direct-current blocking capacitor and the second direct-current blocking capacitor are further added to the impedance module, to prevent the first primary coil and the second primary coil of the composite transformer from introducing extra direct currents, thereby reducing static power consumption of the isolated driver.

In a possible implementation, the first receive link includes a first hysteresis comparator, and the first hysteresis comparator is connected to the first secondary coil, and is configured to receive the first pair of differential triangular pulse signals output by the first secondary coil, and output the first square wave pulse signal; and the second receive link includes a second hysteresis comparator, and the second hysteresis comparator is connected to the second secondary coil, and is configured to receive the second pair of differential triangular pulse signals output by the second secondary coil, and output the second square wave pulse signal.

In this embodiment of this application, the square wave pulse signals are recovered, by using the hysteresis comparators, from the triangular pulse signals output by the secondary coils of the composite transformer, to drive subsequent components connected to the receive links.

According to a second aspect, an embodiment of this application provides an isolated driver, including a transmit link, a composite transformer, a first receive link, and a second receive link. The transmit link is configured to output a square wave pulse signal. The composite transformer includes a first primary coil, a second primary coil, a first secondary coil, and a second secondary coil, where the first primary coil includes a positive input and a negative input, the second primary coil includes a positive input and a negative input, and the negative input of the first primary coil is connected to the positive input of the second primary coil. The composite transformer is configured to receive, by using the first primary coil and the second primary coil, the square wave pulse signal output by the transmit link, generate a first pair of differential triangular pulse signals in a magnetic coupling manner by using the first secondary coil, and generate a second pair of differential triangular pulse signals in a magnetic coupling manner by using the second secondary coil. The first receive link is electrically connected to the first secondary coil, and is configured to receive the first pair of differential triangular pulse signals and output a first square wave pulse signal. The second receive link is electrically connected to the second secondary coil, and is configured to receive the first pair of differential triangular pulse signals and output a second square wave pulse signal. The first square wave pulse signal and the second square wave pulse signal are differential signals of each other.

During implementation of this embodiment of this application, two pulse signals can be transmitted by using one transmit link. Compared with the prior art, one transmit link is saved, and power consumption and costs of the isolated driver are reduced. In addition, the pulse signal output by the transmit link is input to the voltage composite transformer, to output the two pairs of differential signals, thereby reducing delay matching between the two pairs of differential signals, and expanding an application scope of the isolated driver.

In a possible implementation, the isolated driver further includes an impedance module, and the impedance module is configured to reduce overshoot signals of the triangular pulse signals output by the first secondary coil and the second secondary coil.

In this embodiment of this application, the impedance module may be added to adjust a quality factor (a Q value) of the composite transformer, to obtain both high pulse peak values and low overshoot peak values of the output signals of the composite transformer. The high pulse peak values help the receive links to more easily identify the output signals of the composite transformer, and the low overshoot peak values help to shape the output signals of the composite transformer, to prevent the first receive link and the second receive link from incorrectly generating pulses based on the overshoot signals when outputting the square wave pulse signals based on the output signals of the composite transformer, thereby reducing a bit error rate and improving system reliability.

In a possible implementation, the transmit link includes a first output end, configured to output one square wave pulse signal, the positive input of the first primary coil is electrically connected to the first output end of the transmit link, and the negative input of the second secondary coil is grounded.

During implementation of this embodiment of this application, the transmit link can be enabled to output one pulse signal, and the composite transformer is driven to perform magnetic coupling transmission on the pulse signal, to finally output one pair of differential signals, thereby reducing delay matching between the output differential signals.

In a possible implementation, the impedance module includes a first resistor, and the positive input of the first primary coil is electrically connected to the first output end of the transmit link by using the first resistor.

In this embodiment of this application, the impedance module includes the first resistor, and an optimal Q value of the composite transformer is obtained by adjusting a resistance value of the first resistor, to reduce the overshoot signals of the pulse signals output by the composite transformer, to prevent the first receive link and the second receive link from incorrectly generating pulses based on the overshoot signals when outputting the square wave pulse signals based on the output signals of the composite transformer, thereby reducing the bit error rate and improving the system reliability.

In a possible implementation, the impedance module further includes a first direct-current blocking capacitor, and the first resistor is electrically connected to the output end of the transmit link by using the first direct-current blocking capacitor.

In this embodiment of this application, the first direct-current blocking capacitor is further added to the impedance module, to prevent the first primary coil and the second primary coil of the composite transformer from introducing extra direct currents, thereby reducing static power consumption of the isolated driver.

In a possible implementation, the transmit link includes a first output end and a second output end, each of the first output end and the second output end is configured to output one square wave pulse signal, the square wave pulse signals output by the first output end and the second output end are differential signals of each other, the positive input of the first primary coil is electrically connected to the first output end of the transmit link, and the negative input of the second primary coil is electrically connected to the second output end of the transmit link.

During implementation of this embodiment of this application, the transmit link is enabled to output the two square wave pulse signals, and the two square wave pulse signals are input to the voltage composite transformer to output the two pairs of differential triangular pulse signals. Because magnetic fields of the first primary coil and the second primary coil depend on both of the two square wave pulse signals, amplitude and phase self-calibration can be performed on the two square wave pulse signals inside the voltage composite transformer, to reduce delay matching between the output two pairs of differential triangular pulse signals, and reduce delay matching between the square wave pulse signals output by the first receive link and the second receive link.

In a possible implementation, the impedance module includes a first resistor and a second resistor, the positive input of the first primary coil is electrically connected to the first output end of the transmit link by using the first resistor, and the negative input of the second primary coil is electrically connected to the second output end of the transmit link by using the second resistor.

In this embodiment of this application, the impedance module includes the first resistor and the second resistor, and an optimal Q value of the composite transformer is obtained by adjusting resistance values of the first resistor and the second resistor, to reduce the overshoot signals of the pulse signals output by the composite transformer, to prevent the first receive link and the second receive link from incorrectly generating pulses based on the overshoot signals when outputting the square wave pulse signals based on the output signals of the composite transformer, thereby reducing the bit error rate and improving the system reliability.

In a possible implementation, the impedance module further includes a first direct-current blocking capacitor and a second direct-current blocking capacitor, the first resistor is electrically connected to the first output end of the transmit link by using the first direct-current blocking capacitor, and the second resistor is electrically connected to the second output end of the transmit link by using the second direct-current blocking capacitor.

In this embodiment of this application, the first direct-current blocking capacitor and the second direct-current blocking capacitor are further added to the impedance module, to prevent the first primary coil and the second primary coil of the composite transformer from introducing extra direct currents, thereby reducing static power consumption of the isolated driver.

In a possible implementation, the impedance module includes a first resistor, one end of the first resistor is electrically connected to the first output end of the transmit link and the positive input of the first primary coil, and the other end of the first resistor is electrically connected to the second output end of the transmit link and the negative input of the second primary coil.

In this embodiment of this application, the impedance module includes the first resistor, and an optimal Q value of the composite transformer is obtained by adjusting a resistance value of the first resistor, to reduce the overshoot signals of the pulse signals output by the composite transformer, to prevent the first receive link and the second receive link from incorrectly generating pulses based on the overshoot signals when outputting the square wave pulse signals based on the output signals of the composite transformer, thereby reducing the bit error rate and improving the system reliability.

In a possible implementation, the impedance module further includes a first direct-current blocking capacitor and a second direct-current blocking capacitor, the first direct-current blocking capacitor is electrically connected to the first output end of the transmit link and one end of the first resistor, and the second direct-current blocking capacitor is electrically connected to the second output end of the transmit link and the other end of the first resistor.

In this embodiment of this application, the first direct-current blocking capacitor and the second direct-current blocking capacitor are further added to the impedance module, to prevent the first primary coil and the second primary coil of the composite transformer from introducing extra direct currents, thereby reducing static power consumption of the isolated driver.

In a possible implementation, the first receive link includes a first hysteresis comparator, and the first hysteresis comparator is connected to the first secondary coil, and is configured to receive the first pair of differential triangular pulse signals output by the first secondary coil, and output the first square wave pulse signal; and the second receive link includes a second hysteresis comparator, and the second hysteresis comparator is connected to the second secondary coil, and is configured to receive the second pair of differential triangular pulse signals output by the second secondary coil, and output the second square wave pulse signal.

In this embodiment of this application, the square wave pulse signals are recovered, by using the hysteresis comparators, from the triangular pulse signals output by the secondary coils of the composite transformer, to drive subsequent components connected to the receive links.

**BRIEF DESCRIPTION OF DRAWINGS**

To describe the technical solutions in the embodiments of this application or in the prior art more clearly, the following briefly describes the accompanying drawings needed for describing the embodiments or the prior art.

FIG. 1 is a schematic structural diagram of an isolated driver in the prior art;

FIG. 2 is a schematic structural diagram of an isolated driver according to an embodiment of this application;

FIG. 3 is a schematic structural diagram of an isolated driver according to another embodiment of this application;

FIG. 4 is a schematic structural diagram of an isolated driver according to another embodiment of this application;

FIG. 5 is a schematic structural diagram of an isolated driver according to another embodiment of this application;

FIG. 6 is a schematic structural diagram of an isolated driver according to another embodiment of this application;

FIG. 7 is a schematic structural diagram of an isolated driver according to another embodiment of this application;

FIG. 8 is a schematic structural diagram of an isolated driver according to another embodiment of this application;

FIG. 9 is a schematic structural diagram of an isolated driver according to another embodiment of this application;

FIG. 10 is a schematic structural diagram of an isolated driver according to another embodiment of this application;

FIG. 11 is a schematic structural diagram of an isolated driver not covered by the claims.

FIG. 12 is a schematic structural diagram of an isolated driver not covered by the claims.

FIG. 13 is a schematic structural diagram of an isolated driver not covered by the claims.

FIG. 14 is a schematic structural diagram of an isolated driver not covered by the claims.

FIG. 15 is a schematic structural diagram of an isolated driver not covered by the claims.

FIG. 16 is a schematic structural diagram of an isolated driver not covered by the claims.

FIG. 17 is a schematic structural diagram of an isolated driver not covered by the claims.

FIG. 18 is a schematic structural diagram of an isolated driver not covered by the claims.

FIG. 19 is a schematic structural diagram of an isolated driver not covered by the claims.

FIG. 20 is a schematic structural diagram of receive links according to an embodiment of this application;

FIG. 21 is a schematic structural diagram of an isolated driver according to another embodiment of this application; and

FIG. 22 is a schematic structural diagram of an isolated driver according to another embodiment of this application.

**DESCRIPTION OF EMBODIMENTS**

The technical solutions in the embodiments of this application are clearly and completely described below with reference to the accompanying drawings.

An isolated driver provided in the embodiments of this application has a magnetic coupling structure, and may be applied to a high-speed high-voltage isolation structure. Compared with a conventional photoelectric coupling structure, the isolated driver having the magnetic coupling structure in the embodiments of this application has a higher transmission rate, higher precision, and a higher common mode rejection capability.

First, a composite transformer used in the embodiments of this application is described. Each composite transformer includes a first primary coil, a second primary coil, a first secondary coil, and a second secondary coil. Each primary coil includes a positive input (import positive, IP) and a negative input (import negative, IN). In the embodiments of this application, the positive input of the first primary coil is referred to as IP1, the negative input of the first primary coil is referred to as IN1, the positive input of the second primary coil is referred to as IP2, and the negative input of the second primary coil is referred to as IN2. Two types of composite transformers: a current composite transformer and a voltage composite transformer only the current transformer implementation is covered by the claims. A first primary coil and a second primary coil of the current composite transformer are connected in parallel, that is, IP1 is connected to IP2, and IN1 is connected to IN2. A first primary coil and a second primary coil of the voltage composite transformer are connected in series, that is, IN1 is connected to IP2.

It can be learned that a specific manner of connecting the first primary coil and the second primary coil of the voltage composite transformer is not limited to connecting IN1 and IP2, and may be alternatively connecting IP1 and IN2. The specific manner of connecting the first primary coil and the second primary coil of the voltage composite transformer is not limited in the embodiments of this application. The manner of connecting the first primary coil and the second primary coil of the voltage composite transformer is described only by using an example in which IN1 is connected to IP2.

Specifically, "electrical connection" between a component A and a component B in the embodiments of this application is not limited to direct connection between A and B, and may further indicate that the component A is indirectly connected to the component B by using a component C.

The following describes the isolated driver provided in the embodiments of this application.

FIG. 2 shows a structure of an isolated driver according to an embodiment of this application. As shown in FIG. 2, the isolated driver may include at least a transmit link, a current composite transformer, a first receive link, and a second receive link.

The transmit link is configured to output a square wave pulse signal.

Specifically, the transmit link may output one square wave pulse signal, or two differential square wave pulse signals.

The current composite transformer is configured to receive, by using a first primary coil and a second primary coil, the square wave pulse signal output by the transmit link, generate a first pair of differential triangular pulse signals in a magnetic coupling manner by using a first secondary coil, and generate a second pair of differential triangular pulse signals in a magnetic coupling manner by using a second secondary coil.

Specifically, the first secondary coil is magnetically coupled to the first primary coil and the second primary coil, and outputs the first pair of triangular pulse signals by using the square wave pulse signal that is output by the transmit link and that is received by the first primary coil and the second primary coil. The second secondary coil is magnetically coupled to the first primary coil and the second primary coil, and outputs the second pair of triangular pulse signals by using the square wave pulse signal that is output by the transmit link and that is received by the first primary coil and the second primary coil.

The first receive link is electrically connected to the first secondary coil, and is configured to receive the first pair of differential triangular pulse signals and output a first square wave pulse signal.

The second receive link is electrically connected to the second secondary coil, and is configured to receive the second pair of differential triangular pulse signals and output a second square wave pulse signal. The first square wave pulse signal and the second square wave pulse signal are differential signals of each other.

Specifically, the pair of differential square wave pulse signals output by the first receive link and the second receive link are used to drive components connected to the isolated driver. The component connected to the isolated driver may be, for example, an insulated gate bipolar transistor (insulated gate bipolar transistor, IGBT), a lateral diffused metal oxide semiconductor (lateral diffused metal oxide semiconductor, LDMOS), or a gallium nitride (Gallium nitride, GaN) transistor.

Specifically, the first receive link and the second receive link may recover the square wave pulse signals from the triangular pulse signals output by the current composite transformer, and input the recovered square wave pulse signals to drive elements to drive subsequently connected components.

In this embodiment of this application, the current composite transformer is used, so that one transmit link can be saved. Magnetic coupling transmission is performed on the square wave pulse signal transmitted by the transmit link, to finally output the two pairs of differential triangular pulse signals, thereby reducing a delay between the two pairs of differential triangular pulse signals, and reducing power consumption and costs of the isolated driver.

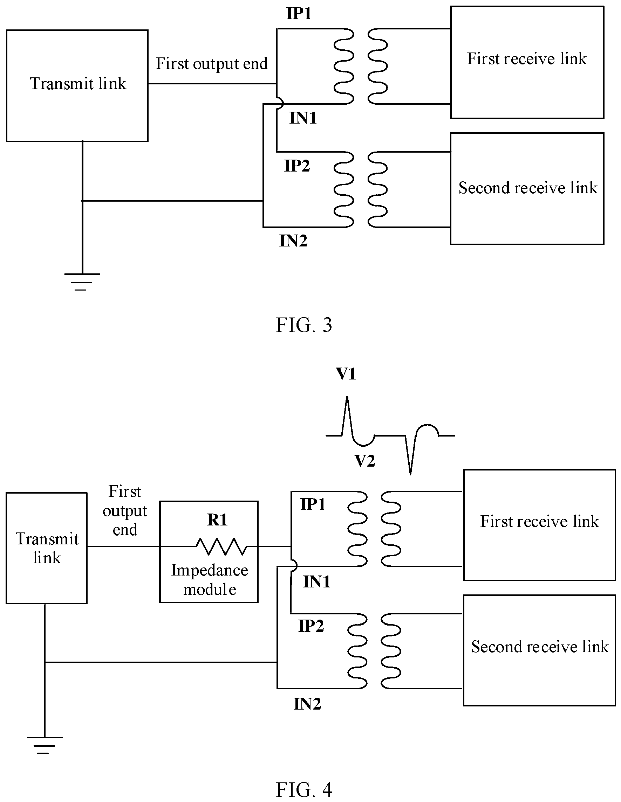

In a possible embodiment, the transmit link of the isolated driver includes a first output end (OUT), configured to output one square wave pulse signal. As shown in FIG. 3, a positive input IP1 of the first primary coil and a positive input IP2 of the second primary coil of the current composite transformer are connected to the first output end OUT of the transmit link, and a negative input IN1 of the first primary coil and a negative input IN2 of the second secondary coil of the current composite transformer are grounded. It can be learned that the first primary coil and the second primary coil of the current composite transformer are connected in parallel, that is, IP1 is connected to IP2, and IN1 is connected to IN2.

Further, because a path damping coefficient of the current composite transformer is small, ringdown is generated, and as a result, overshooting exists in the output signals of the current composite transformer. Therefore, the pulse signals need to be shaped. Therefore, the isolated driver may further include an impedance module.

In a possible embodiment, the impedance module may include a first resistor R1. As shown in FIG. 4, the first resistor R1 is connected to the first output end OUT of the transmit link and the IP1 and the IP2 of the current composite transformer, and is configured to adjust a Q value of the current composite transformer, to obtain both high pulse peak values V1 and low overshoot peak values V2. The high pulse peak values V1 help the first receive link and the second receive link to more easily identify the triangular pulse signals output by the current composite transformer. The low overshoot peak values V2 are intended to reduce a bit error rate.

Specifically, because the overshoot peak values V2 are in direct proportion to the Q value of the current composite transformer, and the pulse peak values V1 are in direct proportion to a change rate of a drive current, theoretically, an optimal Q value is equal to $(1/\text{minimum pulse width})*2\pi f$, where the minimum pulse width is duration of a high level of the pulse signal output by the transmit link, f is a frequency of the pulse signal output by the transmit link, and the change rate of the drive current depends on a drive capability of an output circuit of the transmit link TX. The optimal Q value means that both the high pulse peak values V1 and the low overshoot peak values V2 are considered.

It can be learned from the formula

$$Q = \frac{2\pi f * L}{R}$$

that the Q value of the transformer may be adjusted by adjusting an inductance value L of an inductor of a primary coil and a resistance value R of the first resistor R1. Therefore, the theoretical optimal Q value may be obtained by properly increasing the inductance value L of the primary coil inductor of the transformer and the resistance value R of the first resistor R1, to obtain both the high pulse peak values V1 and the low overshoot peak values V2, thereby improving system reliability and reducing the bit error rate.

Specifically, reducing the bit error rate means that because the first receive link and the second receive link may incorrectly recover the signals based on the overshoot signals when subsequently recovering the square wave signals based on the triangular pulse signals output by the transformer, the finally recovered signals are inaccurate. Therefore, after the first resistor R1 is added, the Q value of the transformer may be adjusted to obtain the relatively low overshoot peak values V2, thereby reducing the bit error rate. For example, if the first receive link recovers, by using a hysteresis comparator, the square wave pulse signal from the triangular pulse signals output by the transformer, a maximum threshold $V_{max}$ and a minimum threshold $V_{min}$ of the hysteresis comparator may be preset, and when voltage values of the triangular pulse signals output by the transformer are greater than the maximum threshold $V_{max}$ of the hysteresis comparator, the output square wave pulse signal is inverted, or when the voltage values of the triangular pulse signals output by the transformer are less than the minimum threshold $V_{min}$ of the hysteresis comparator, a level of the output square wave pulse signal is inverted again. If the overshoot peak values V2 of the triangular pulse signals output by the transformer are greater than the maximum threshold $V_{max}$ of the hysteresis comparator or less than the minimum threshold $V_{min}$ of the hysteresis comparator, the hysteresis comparator incorrectly inverts the output square wave pulse signal based on the overshoot signals. As a result, the finally recovered signal is inaccurate. Therefore, after the overshoot peak values V2 are reduced, a probability that the hysteresis comparator inverts the output square wave pulse signal based on the overshoot peak values V2 can be reduced, thereby reducing the bit error rate and improving the system reliability.

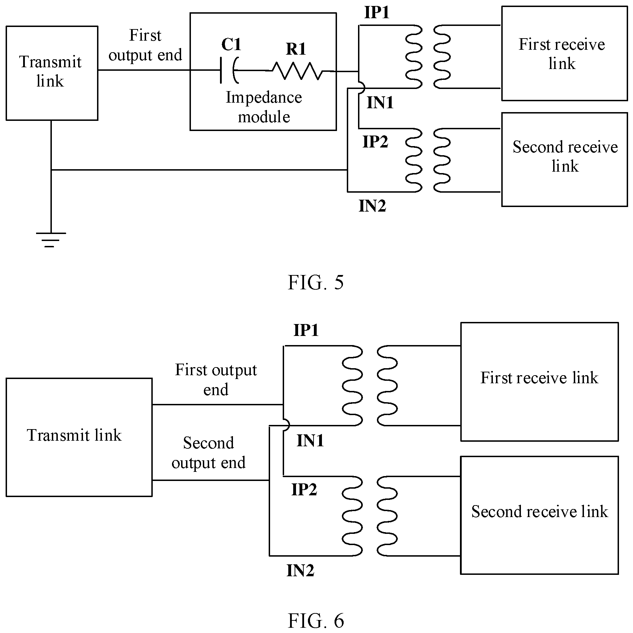

Further, the impedance module may further include a first direct-current blocking capacitor C1. As shown in FIG. 5, the first resistor R1 may be connected to the first output end OUT of the transmit link by using the first direct-current blocking capacitor C1, to prevent the primary coils of the current composite transformer from introducing extra direct currents, thereby reducing static power consumption of the isolated driver.

In another possible embodiment, the transmit link of the isolated driver includes a first output end OUT 1 and a second output end OUT2, each of the first output end OUT1 and the second output end OUT2 is configured to output one square wave pulse signal, and the square wave pulse signals output by the first output end OUT1 and the second output end OUT1 are differential signals of each other. As shown in FIG. 6, a positive input IP1 of the first primary coil and a positive input IP2 of the second primary coil of the current composite transformer are connected to the first output end OUT1 of the transmit link, and a negative input IN1 of the first primary coil and a negative input IN2 of the second primary coil of the current composite transformer are connected to the second output end OUT2 of the transmit link. It can be learned that the first primary coil and the second primary coil of the current composite transformer are connected in parallel, that is, IP1 is connected to IP2, and IN1 is connected to IN2.

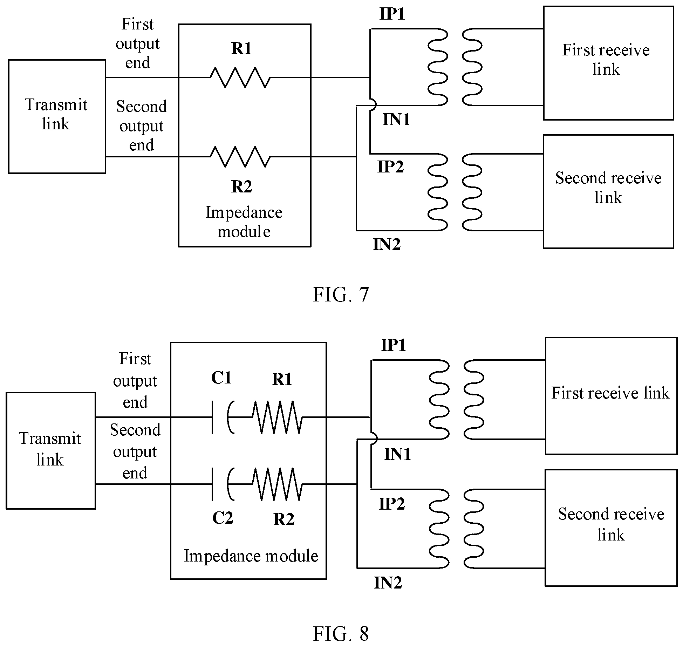

Optionally, the isolated driver further includes an impedance module, and the impedance module may include a first resistor R1 and a second resistor R2. As shown in FIG. 7, the positive input IP1 of the first primary coil is connected to the first output end OUT1 of the transmit link by using the first resistor R1, and the negative input of the second primary coil is connected to the second output end OUT2 of the transmit link by using the second resistor R2. The first resistor R1 and the second resistor R2 are configured to adjust a Q value of the current composite transformer, to obtain both high pulse peak values V1 and low overshoot peak values V2, to shape the pulse signals and reduce a bit error rate. Specifically, for a pulse signal shaping principle, refer to the embodiment of FIG. 4, and details are not described herein again.

Further, the impedance module further includes a first direct-current blocking capacitor C1 and a second direct-current blocking capacitor C2. As shown in FIG. 8, the first resistor R1 is connected to the first output end OUT1 of the transmit link by using the first direct-current blocking capacitor C1, and the second resistor R2 is connected to the second output end OUT2 of the transmit link by using the second direct-current blocking capacitor C2, to prevent the primary coils of the composite transformer from introducing extra direct currents, thereby reducing static power consumption of the isolated driver.

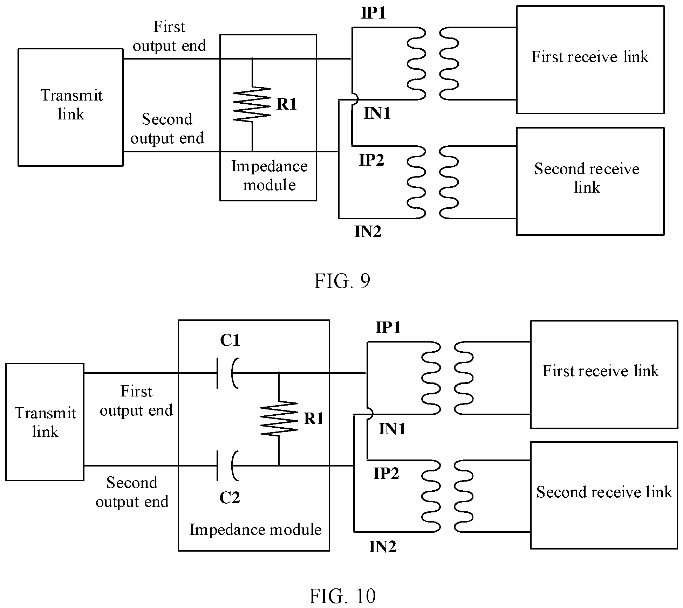

Optionally, the impedance module alternatively includes a first resistor R1. As shown in FIG. 9, the first resistor R1 is connected in parallel to two ends of the two primary coils of the current composite transformer, one end of the first resistor R1 is connected to the positive input IP1 of the first primary coil, the positive input IP2 of the second primary coil, and the first output end OUT1 of the transmit link, and the other end of the first resistor R1 is connected to the negative input IP1 of the first primary coil, the negative input IP2 of the second primary coil, and the second output end OUT2 of the transmit link. The first resistor R1 is configured to adjust a Q value of the current composite transformer, to obtain both high pulse peak values V1 and low overshoot peak values V2, to shape the pulse signals and reduce a bit error rate. Specifically, for a pulse signal shaping principle, refer to the embodiment of FIG. 4, and details are not described herein again.

Further, the impedance module alternatively includes a first direct-current blocking capacitor C1 and a second direct-current blocking capacitor C2. As shown in FIG. 10, the first direct-current blocking capacitor C1 is connected to the first output end OUT1 of the transmit link and one end of the first resistor R1, and the second direct-current blocking capacitor C2 is connected to the second output end OUT2 of the transmit link and the other end of the first resistor R1, to prevent the primary coils of the composite transformer from introducing extra direct currents, thereby reducing static power consumption of the isolated driver.

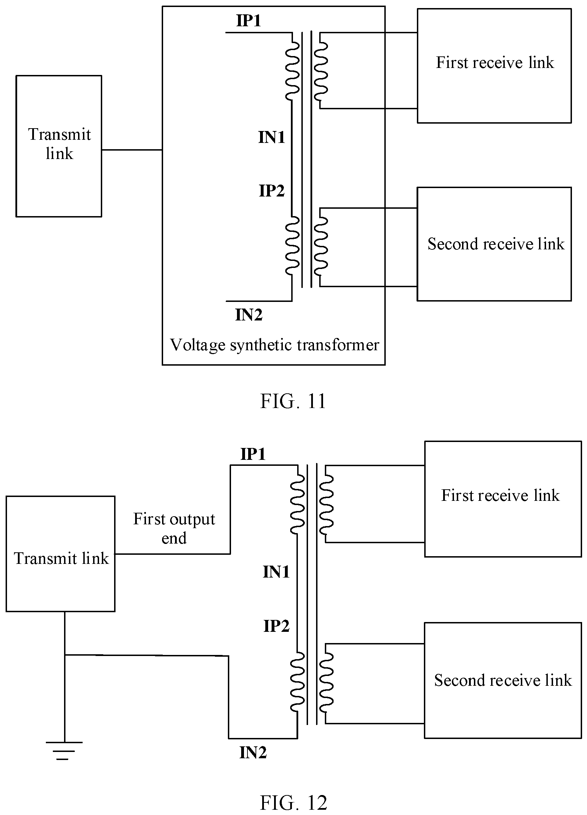

FIG. 11 shows a structure of another isolated driver according to an example not covered by the claims. As shown in FIG. 11, the isolated driver may include at least a transmit link, a voltage composite transformer, a first receive link, and a second receive link.

The transmit link is configured to output a square wave pulse signal.

Specifically, the transmit link may output one square wave pulse signal, or two differential square wave pulse signals.

The voltage composite transformer is configured to receive, by using a first primary coil and a second primary coil, the square wave pulse signal output by the transmit link, generate a first pair of differential triangular pulse signals in a magnetic coupling manner by using a first secondary coil, and generate a second pair of differential triangular pulse signals in a magnetic coupling manner by using a second secondary coil.

Specifically, the first secondary coil is magnetically coupled to the first primary coil and the second primary coil, and outputs the first pair of triangular pulse signals by using the square wave pulse signal that is output by the transmit link and that is received by the first primary coil and the second primary coil. The second secondary coil is magnetically coupled to the first primary coil and the second primary coil, and outputs the second pair of triangular pulse signals by using the square wave pulse signal that is output by the transmit link and that is received by the first primary coil and the second primary coil.

The first receive link is electrically connected to the first secondary coil, and is configured to receive the first pair of differential triangular pulse signals and output a first square wave pulse signal.

The second receive link is electrically connected to the second secondary coil, and is configured to receive the first pair of differential triangular pulse signals and output a second square wave pulse signal. The first square wave pulse signal and the second square wave pulse signal are differential signals of each other.

Specifically, the pair of differential square wave pulse signals output by the first receive link and the second receive link are used to drive components connected to the isolated driver. The component connected to the isolated driver may be, for example, an IGBT, an LDMOS, or a GaN transistor.

Specifically, the first receive link and the second receive link may recover the square wave pulse signals from the triangular pulse signals output by the voltage composite transformer, and input the recovered square wave pulse signals to drive elements to drive subsequently connected components.

In this example not covered by the claims, the voltage composite transformer is used, so that one transmit link can be saved. Magnetic coupling transmission is performed on the square wave pulse signal transmitted by the transmit link, to finally output the two pairs of differential triangular pulse signals, thereby reducing a delay between the two pairs of differential triangular pulse signals, and reducing power consumption and costs of the isolated driver.

In an example not covered by the claims, the transmit link of the isolated driver includes a first output end (OUT), configured to output one square wave pulse signal. As shown in FIG. 12, a positive input IP1 of the first primary coil of the voltage composite transformer is connected to the first output end OUT of the transmit link, and a negative input IN2 of the second primary coil of the voltage composite transformer is grounded. It can be learned that the first primary coil and the second primary coil of the voltage composite transformer are connected in series. Therefore, a negative input IN1 of the first primary coil is connected to a positive input IP2 of the second primary coil.

Further, because a path damping coefficient of the voltage composite transformer is small, ringdown is generated, and as a result, overshooting exists in the output signals of the voltage composite transformer. Therefore, the pulse signals need to be shaped. Therefore, the isolated driver may further include an impedance module.

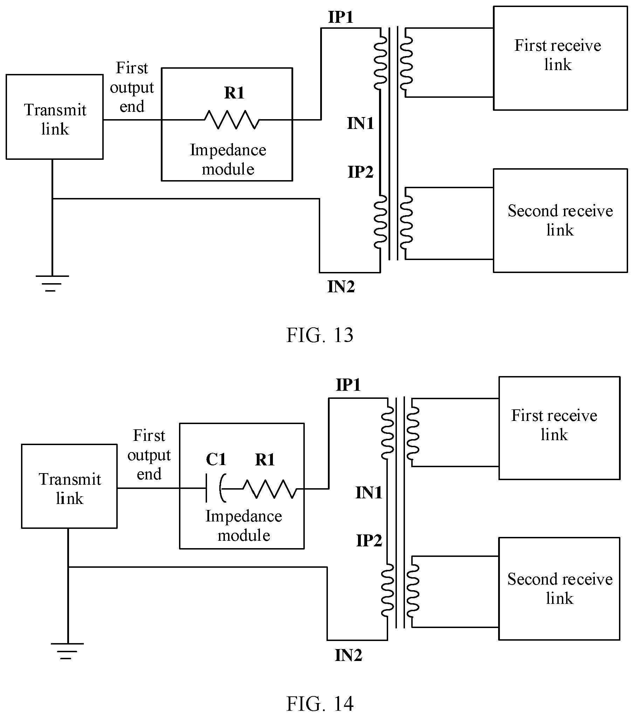

In a possible modification of this example not covered by the claims, the impedance module may include a first resistor R1. As shown in FIG. 13, the positive input IP1 of the first primary coil is connected to the first output end OUT of the transmit link by using the first resistor R1. The first resistor R1 is configured to adjust a Q value of the voltage composite transformer, to obtain both high pulse peak values V1 and low overshoot peak values V2, to shape the pulse signals and reduce a bit error rate. Specifically, for a pulse signal shaping principle, refer to descriptions in the embodiment of FIG. 4, and details are not described herein again.

Further, the impedance module may further include a first direct-current blocking capacitor C1. As shown in FIG. 14, the first resistor R1 is connected to the first output end OUT of the transmit link by using the first direct-current blocking capacitor C1, to prevent the primary coils of the composite transformer from introducing extra direct currents, thereby reducing static power consumption of the isolated driver.

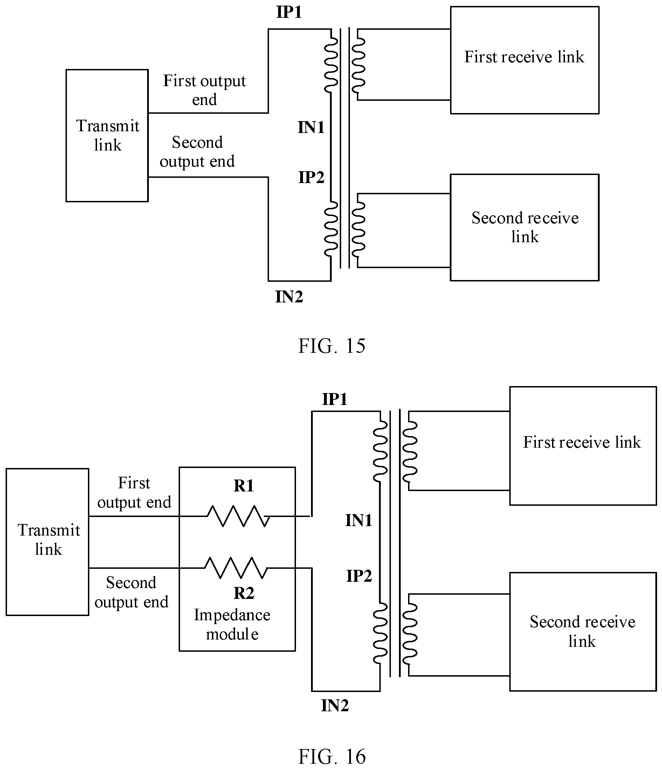

In another example not covered by the claims, the transmit link of the isolated driver includes a first output end OUT 1 and a second output end OUT2, each of the first output end OUT1 and the second output end OUT2 is configured to output one square wave pulse signal, and the square wave pulse signals output by the first output end OUT1 and the second output end OUT1 are differential signals of each other. As shown in FIG. 15, a positive input IP1 of the first primary coil of the voltage composite transformer is connected to the first output end OUT1 of the transmit link, and a negative input IN2 of the second primary coil of the voltage composite transformer is connected to the second output end OUT2 of the transmit link. It can be learned that the first primary coil and the second primary coil of the voltage composite transformer are connected in series. Therefore, a negative input IN1 of the first primary coil is connected to a positive input IP2 of the second primary coil.

Optionally, the isolated driver further includes an impedance module, and the impedance module may include a first resistor R1 and a second resistor R2. As shown in FIG. 16, the positive input IP1 of the first primary coil of the voltage composite transformer is connected to the first output end OUT1 of the transmit link by using the first resistor R1, and the negative input IN2 of the second primary coil of the voltage composite transformer is connected to the second output end OUT2 of the transmit link by using the second resistor R2. The first resistor R1 and the second resistor R2 are configured to adjust a Q value of the voltage composite transformer, to obtain both high pulse peak values V1 and low overshoot peak values V2, to shape the pulse signals and reduce a bit error rate. Specifically, for a pulse signal shaping principle, refer to the embodiment of FIG. 4, and details are not described herein again.

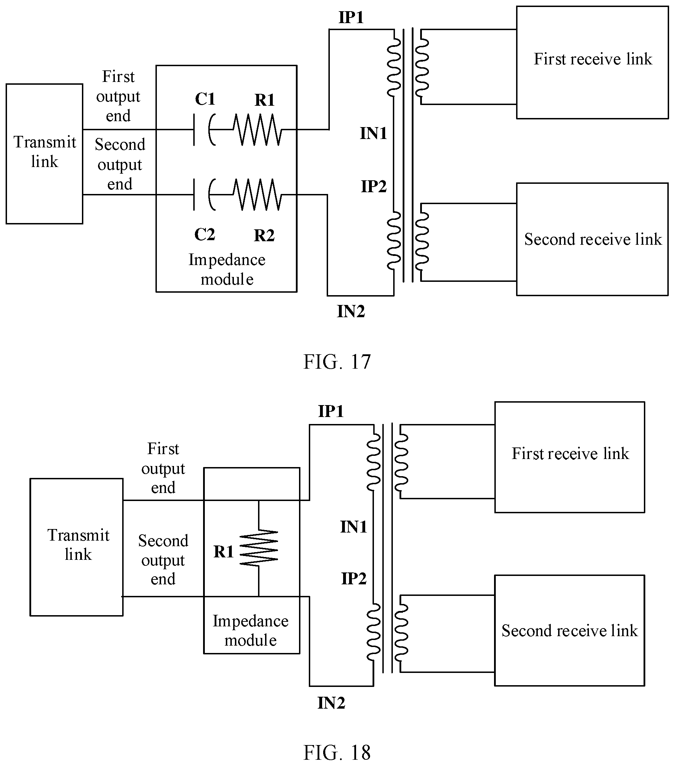

Further, the impedance module further includes a first direct-current blocking capacitor C1 and a second direct-current blocking capacitor C2. As shown in FIG. 17, the first resistor R1 is connected to the first output end OUT1 of the transmit link by using the first direct-current blocking capacitor C1, and the second resistor R2 is connected to the second output end OUT2 of the transmit link by using the second direct-current blocking capacitor C2, to prevent the primary coils of the composite transformer from introducing extra direct currents, thereby reducing static power consumption of the isolated driver.

Optionally, the impedance module alternatively includes a first resistor R1. As shown in FIG. 18, the first resistor R1 is connected in parallel to two ends of the two primary coils of the voltage composite transformer, one end of the first resistor R1 is connected to the positive input IP1 of the first primary coil and the first output end OUT1 of the transmit link, and the other end of the first resistor R1 is connected to the negative input IP2 of the second primary coil and the second output end OUT2 of the transmit link. The first resistor R1 is configured to adjust a Q value of the voltage composite transformer, to obtain both high pulse peak values V1 and low overshoot peak values V2, to shape the pulse signals and reduce a bit error rate. Specifically, for a pulse signal shaping principle, refer to the embodiment of FIG. 4, and details are not described herein again.

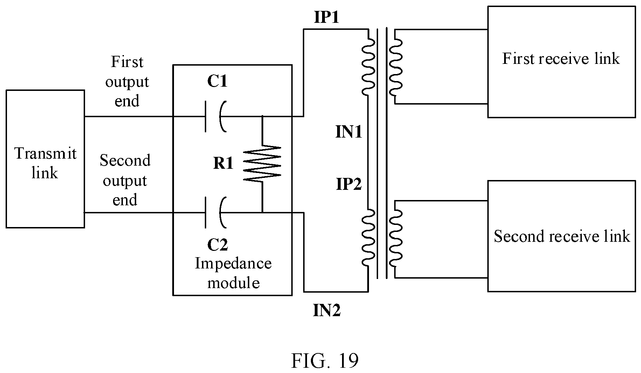

Further, the impedance module further includes a first direct-current blocking capacitor C1 and a second direct-current blocking capacitor C2. As shown in FIG. 19, the first direct-current blocking capacitor C1 is connected to the first output end OUT1 of the transmit link and one end of the first resistor R1, and the second direct-current blocking capacitor C2 is connected to the second output end OUT2 of the transmit link and the other end of the first resistor R1, to prevent the primary coils of the composite transformer from introducing extra direct currents, thereby reducing static power consumption of the isolated driver.

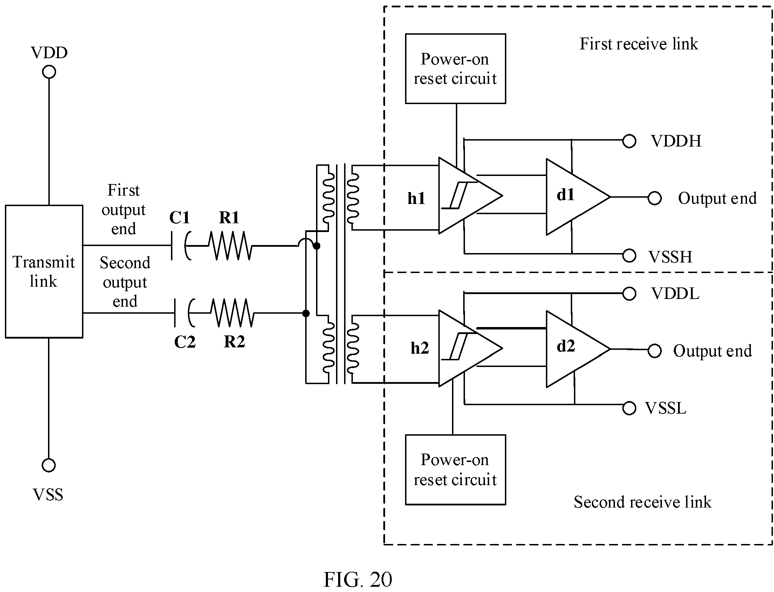

FIG. 20 is a structural diagram of the first receive link and the second receive link in the embodiments of this application. As shown in FIG. 20, the first receive link includes a first hysteresis comparator h1, a power-on reset (Power-On Reset, POR) circuit, and a drive element d1, and the second receive link includes a second hysteresis comparator h2, a power-on reset POR circuit, and a drive element d2.

The first hysteresis comparator h1 and the second hysteresis comparator h2 are respectively connected to the first secondary coil and the second secondary coil of the composite transformer, and are configured to recover the square wave pulse signals from the triangular pulse signals output by the secondary coils. A user may preset a maximum threshold $V_{max}$ and a minimum threshold $V_{min}$ of a hysteresis comparator. When voltage values of triangular pulse signals output by a secondary coil are greater than a maximum threshold $V_{max}$ of a hysteresis comparator, an output square wave pulse signal is set to a high level, or when voltage values of triangular pulse signals output by a secondary coil are less than a minimum threshold $V_{min}$ of a comparator, an output square wave pulse signal is inverted from a high level to a low level, to recover the square wave pulse signals from the triangular pulse signals output by the composite transformer.

The power-on reset POR circuit is configured to set initial output levels of the square wave pulse signals output by the hysteresis comparator h1 and the hysteresis comparator h2.

An output end OUT1 of the drive element 1 and an output end OUT2 of the drive element 2 output one pair of differential square wave pulse signals, to drive drive components subsequently connected to the isolated driver. The drive component, for example, may be but is not limited to an IGBT, an LDMOS, and a GaN transistor.

It can be learned that the isolated driver has three voltage domains: VDD and VSS, VDDH and VSSH, and VDDL and VSSL. The last two voltage domains are high voltage domains, and the first is a low voltage domain. The high voltage domain and the low voltage domain are isolated by using the composite transformer.

The receive links shown in FIG. 20 are merely example description. In an actual use process, the receive links may have other structures provided that a function of recovering the square wave pulse signals from the triangular pulse signals and a function of driving subsequent drive components are implemented. This is not limited in this embodiment of this application.

FIG. 20 is described only by using an example in which the transmit link outputs two pulse signals, the composite transformer is a current composite transformer, and the impedance module includes a first resistor R1, a second resistor R2, a first direct-current blocking capacitor C1, and a second direct-current blocking capacitor C2. The receive links shown in FIG. 20 are applicable to the isolated drivers provided in all the embodiments of this application.

Because a path damping coefficient of the composite transformer is small, ringdown is generated, and as a result, an overshoot signal of the pulse signal output by the transmit link occurs in the transformer. Consequently, both pulse peak values V1 and overshoot peak values V2 exist in the differential triangular pulse signals output by the transformer, and the receive links may incorrectly invert the pulse signals based on the overshoot signals V2 when recovering the square wave pulse signals from the triangular pulse signals output by the transformer, leading to occurrence of error bits in the finally recovered square wave pulse signals. However, in the prior art, to shape the pulse signals output by the transformer and reduce the bit error rate, a current limiter is added to the transmit link, and a low-speed pulse shaping circuit is added between the transformer and the receive links. This not only increases power consumption and costs of the isolated driver, but also limits a communication rate.

Therefore, an embodiment of this application further provides an isolated driver, to shape pulse signals output by a transformer, avoid false triggering caused by overshoot signals, reduce a bit error rate, reduce power consumption and costs, and increase a communication rate.

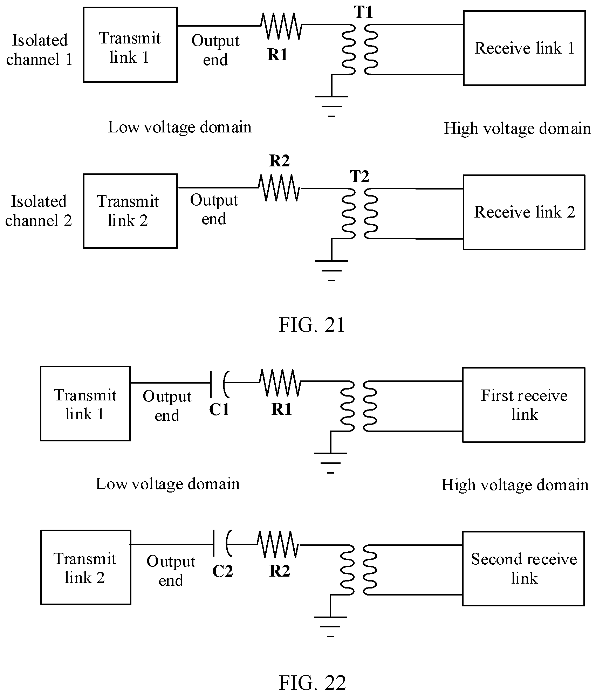

FIG. 21 shows an isolated driver according to an embodiment of this application. The isolated driver includes two independent isolated channels: an isolated channel 1 and an isolated channel 2. The isolated channel 1 includes a transmit link 1, a first resistor R1, a first transformer T1, and a receive link 1. The isolated channel 2 includes a transmit link 2, a second resistor R2, a second transformer T2, and a receive link 2.

Each of the transmit link 1 and the transmit link 2 is configured to output one pulse signal, and the pulse signal output by the transmit link 1 and the pulse signal output by the transmit link 2 are differential signals of each other

Specifically, the pulse signals output by the transmit link 1 and the transmit link 2 may be square wave pulse signals.

The first resistor R1 is connected to an output end OUT1 of the transmit link 1 and one end of a primary coil of the first transformer T1, and is configured to adjust a Q value of the first transformer T1.

The second resistor R2 is connected to an output end OUT2 of the transmit link 2 and one end of a primary coil of the second transformer T2, and is configured to adjust a Q value of the second transformer T2.

Specifically, the first resistor R1 and the second resistor R2 adjust the Q values of the transformers, to obtain both high pulse peak values V1 and low overshoot peak values V2, to shape pulse signals and reduce a bit error rate. For a principle of shaping the pulse signals by the first resistor R1 and the second resistor R2, refer to the descriptions in the embodiment of FIG. 4, and details are not described herein again.

The first transformer T1 is connected to the output end OUT1 of the transmit link 1 by using the first resistor R1, and is configured to receive the pulse signal output by the transmit link 1, output a pair of differential pulse signals based on the pulse signal output by the transmit link 1, and transmit the pair of differential pulse signals to the receive link 1. The differential pulse signals output by the first transformer T1 are differential triangular pulse signals.

The second transformer T2 is connected to the output end OUT2 of the transmit link 2 by using the second resistor R2, and is configured to receive the pulse signal output by the transmit link 2, output a pair of differential pulse signals based on the pulse signal output by the transmit link 2, and transmit the pair of differential pulse signals to the receive link 2. The differential pulse signals output by the second transformer T2 are differential triangular pulse signals.

The receive link 1 and the receive link 2 are respectively connected to a secondary coil of the first transformer T1 and a secondary coil of the second transformer T2, and are configured to receive the pulse signals output by the first transformer T1 and the second transformer T2, process the signals, and each output one pulse signal. The pulse signals output by the receive link 1 and the receive link 2 are square wave pulse signals, and the pulse signals output by the receive link 1 and the receive link 2 are differential pulse signals of each other.

Specifically, the receive link 1 may restore, by using a hysteresis comparator, the triangular pulse signals output by the first transformer T1, to recover the square wave pulse signal from the triangular pulse signals output by the first transformer T1, and drive, by using a drive component, a component subsequently connected to the receive link 1. The component subsequently connected to the receive link 1 may be but is not limited to an IGBT, an LDMOS, and a GaN transistor.

Specifically, the receive link 2 may restore, by using a hysteresis comparator, the triangular pulse signals output by the second transformer T2, to recover the square wave pulse signal from the triangular pulse signals output by the second transformer T2, and drive, by using a drive component, a component subsequently connected to the receive link 2. The component subsequently connected to the receive link 2 may be but is not limited to an IGBT, an LDMOS, and a GaN transistor.

The receive link 1 or the receive link 2 may recover, in another manner or by using another element, the square wave pulse signal from the triangular pulse signals output by the first transformer T1 or the second transformer T2, and the receive link 1 or the receive link 2 may also drive, in another manner or by using another element, the subsequently connected component. This embodiment of this application is merely example description, and this is not limited herein again.

Further, the isolated driver may further include a first direct-current blocking capacitor C1 and a second direct-current blocking capacitor C2. As shown in FIG. 22, the first resistor R1 may be connected to the output end OUT1 of the transmit link 1 by using the first direct-current blocking capacitor C1, and the second resistor R2 may be connected to the output end OUT2 of the transmit link 2 by using the second direct-current blocking capacitor C2, to prevent the primary coils of the composite transformer from introducing extra direct currents, thereby reducing static power consumption of the isolated driver.

During implementation of this embodiment of this application, the resistor may be added between the transformer and the transmit link to adjust the Q value of the transformer, to shape the pulse signals, reduce system power consumption and costs, reduce the bit error rate, and increase a communication rate.

## Claims

1. An isolated driver, comprising: a transmit link, a current composite transformer, a first receive link, and a second receive link, wherein

   the transmit link is configured to output a square wave pulse signal;
   the current composite transformer comprises a first primary coil, a second primary coil, a first secondary coil, and a second secondary coil, wherein the first primary coil comprises a positive input (IP1) and a negative input (IN1), the second primary coil comprises a positive input (IP2) and a negative input (IN2), the positive input of the first primary coil is electrically connected to the positive input of the second primary coil, and the negative input of the first primary coil is electrically connected to the negative input of the second primary coil; the current composite transformer is configured to receive the square wave pulse signal by using the first primary coil, the second primary coil, generate a first pair of differential triangular pulse signals in a magnetic coupling manner by using the first secondary coil, and generate a second pair of differential triangular pulse signals in a magnetic coupling manner by using the second secondary coil;
   the first receive link is electrically connected to the first secondary coil, and is configured to receive the first pair of differential triangular pulse signals and output a first square wave pulse signal, the first receive link comprising a first hysteresis comparator (h1), a power-on reset circuit and a drive element (d1),
   wherein the first hysteresis comparator (h1) is connected to the first secondary coil of the current composite transformer and is configured to receive the first pair of differential triangular pulse signals and, when voltage values of triangular pulse signals output by the first secondary coil are greater than a predetermined maximum threshold of the first hysteresis comparator, a square wave pulse signal output by the first hysteresis comparator is set to a high level and, when voltage values of triangular pulse signals output by the first secondary coil are lower than a predetermined minimum threshold of the first hysteresis comparator, the square wave pulse signal output by the first hysteresis comparator is inverted from a high level to a low level, wherein the power-on reset circuit of the first receive link is configured to set an initial output level of the square wave pulse signal output by the first hysteresis comparator (h1); and the second receive link is electrically connected to the second secondary coil, and is configured to receive the second pair of differential triangular pulse signals and output a second square wave pulse signal, the second receive link comprising a second hysteresis comparator (h2), a power-on reset circuit and a drive element (d2), wherein the second hysteresis comparator (h2) is connected to the second secondary coil of the current composite transformer and is configured to receive the second pair of differential triangular pulse signals and, when voltage values of triangular pulse signals output by the second secondary coil are greater than a predetermined maximum threshold of the second hysteresis comparator, a square wave pulse signal output by the second hysteresis comparator is set to a high level and, when voltage values of triangular pulse signals output by the second secondary coil are lower than a predetermined minimum threshold of the second hysteresis comparator, the square wave pulse signal output by the second hysteresis comparator is inverted from a high level to a low level, wherein the power-on reset circuit of the second receive link is configured to set an initial output level of the square wave pulse signal output by the second hysteresis comparator (h2), wherein the first square wave pulse signal and the second square wave pulse signal are differential signals of each other.

2. The isolated driver according to claim 1, wherein the isolated driver further comprises an impedance module, and the impedance module is configured to reduce overshoot signals of the triangular pulse signals output by the first secondary coil and the second secondary coil, wherein the transmit link comprises a first output end, configured to output one square wave pulse signal; the positive input of the first primary coil and the positive input of the second primary coil are electrically connected to the first output end of the transmit link; and the negative input of the first primary coil and the negative input of the second primary coil are grounded, wherein the impedance module comprises a first resistor (R1), and the positive input (IP1) of the first primary coil and the positive input (IP2) of the second primary coil are electrically connected to the first output end of the transmit link by using the first resistor.

3. The isolated driver according to claim 2, wherein the impedance module further comprises a first direct-current blocking capacitor (C1), and the first resistor (R1) is electrically connected to the output end of the transmit link by using the first direct-current blocking capacitor.

4. The isolated driver according to claim 1, wherein the isolated driver further comprises an impedance module, and the impedance module is configured to reduce overshoot signals of the triangular pulse signals output by the first secondary coil and the second secondary coil, wherein the transmit link comprises a first output end and a second output end; each of the first output end and the second output end is configured to output one square wave pulse signal; the square wave pulse signals output by the first output end and the second output end are differential signals of each other; the positive input (IP1) of the first primary coil and the positive input (IP2) of the second primary coil are electrically connected to the first output end of the transmit link; and the negative input (IN1) of the first primary coil and the negative input (IN2) of the second primary coil are electrically connected to the second output end of the transmit link, wherein the impedance module comprises a first resistor (R1) and a second resistor (R2); the positive input (IP1) of the first primary coil and the positive input (IP2) of the second primary coil are electrically connected to the first output end of the transmit link by using the first resistor (R1); and the negative input (IN1) of the first primary coil and the negative input (IN2) of the second primary coil are electrically connected to the second output end of the transmit link by using the second resistor (R2).

5. The isolated driver according to claim 4, wherein the impedance module further comprises a first direct-current blocking capacitor (C1) and a second direct-current blocking capacitor (C2); the first resistor (R1) is electrically connected to the first output end of the transmit link by using the first direct-current blocking capacitor; and the second resistor (R2) is electrically connected to the second output end of the transmit link by using the second direct-current blocking capacitor.

6. The isolated driver according to claim 1, wherein the isolated driver further comprises an impedance module, and the impedance module is configured to reduce overshoot signals of the triangular pulse signals output by the first secondary coil and the second secondary coil, wherein the transmit link comprises a first output end and a second output end; each of the first output end and the second output end is configured to output one square wave pulse signal; the square wave pulse signals output by the first output end and the second output end are differential signals of each other; the positive input (IP1) of the first primary coil and the positive input (IP2) of the second primary coil are electrically connected to the first output end of the transmit link; and the negative input (IN1) of the first primary coil and the negative input (IN2) of the second primary coil are electrically connected to the second output end of the transmit link, wherein the impedance module comprises a first resistor (R1); one end of the first resistor is electrically connected to the first output end of the transmit link, the positive input of the first primary coil, and the positive input of the second primary coil; and the other end of the first resistor is electrically connected to the second output end of the transmit link, the negative input of the first primary coil, and the negative input of the second primary coil.

7. The isolated driver according to claim 6, wherein the impedance module further comprises a first direct-current blocking capacitor (C1) and a second direct-current blocking capacitor (C2); the first direct-current blocking capacitor is electrically connected to the first output end of the transmit link and one end of the first resistor (R1); and the second direct-current blocking capacitor is electrically connected to the second output end of the transmit link and the other end of the first resistor.

**Patentansprüche**

1. Isolierter Treiber, umfassend: eine Übertragungsverbindung, einen Stromverbundtransformator, eine erste Empfangsverbindung und eine zweite Empfangsverbindung, wobei

die Übertragungsverbindung konfiguriert ist zum Ausgeben eines Rechteckwellen-Impulssignals,
der Stromverbundtransformator eine erste Primärspule, eine zweite Primärspule, eine erste Sekundärspule und eine zweite Sekundärspule umfasst, wobei die erste Primärspule einen positiven Eingang (IP1) und einen negativen Eingang (IN1) umfasst, die zweite Primärspule einen positiven Eingang (IP2) und einen negativen Eingang (IN2) umfasst, der positive Eingang der ersten Primärspule mit dem positiven Eingang der zweiten Primärspule elektrisch verbunden ist und der negative Eingang der ersten Primärspule mit dem negativen Eingang der zweiten Primärspule elektrisch verbunden ist;
der Stromverbundtransformator konfiguriert ist zum Empfangen des Rechteckwellen-Impulssignals unter Verwendung der ersten Primärspule, der zweiten Primärspule, Erzeugen eines ersten Paars von differentiellen Dreiecksimpulssignalen in einer Weise der magnetischen Kopplung unter Verwendung der ersten Sekundärspule und Erzeugen eines zweiten Paars von differentiellen Dreiecksimpulssignalen in einer Weise der magnetischen Kopplung unter Verwendung der zweiten Sekundärspule;
die erste Empfangsverbindung mit der ersten Sekundärspule elektrisch verbunden ist und konfiguriert ist zum Empfangen des ersten Paars von differentiellen Dreiecksimpulssignalen und Ausgeben eines ersten Rechteckwellen-Impulssignals, die erste Empfangsverbindung umfassend einen ersten Hysteresekomparator (h1), eine Einschalt-Rücksetzschaltung und ein Ansteuerungselement (d1),
wobei der erste Hysteresekomparator (h1) mit der ersten Sekundärspule des Stromverbundtransformators verbunden ist und konfiguriert ist zum Empfangen des ersten Paars von differentiellen Dreiecksimpulssignalen und, wenn durch die erste Sekundärspule ausgegebene Spannungswerte von Dreiecksimpulssignalen größer als ein im Voraus bestimmter maximaler Schwellenwert des ersten Hysteresekomparators sind, ein durch den ersten Hysteresekomparator ausgegebenes Rechteckwellen-Impulssignal auf einen hohen Pegel eingestellt wird und, wenn durch die erste Sekundärspule ausgegebene Spannungswerte von Dreiecksimpulssignalen niedriger als ein im Voraus bestimmter minimaler Schwellenwert des ersten Hysteresekomparators sind, das durch den ersten Hysteresekomparator ausgegebene Rechteckwellen-Impulssignal von einem hohen Pegel zu einem niedrigen Pegel invertiert wird,
wobei die Einschalt-Rücksetzschaltung der ersten Empfangsverbindung konfiguriert ist zum Einstellen eines anfänglichen Ausgangspegels des durch den ersten Hysteresekomparator (h1) ausgegebenen Rechteckwellen-Impulssignals; und
die zweite Empfangsverbindung mit der zweiten Sekundärspule elektrisch verbunden ist und konfiguriert ist zum Empfangen des zweiten Paars von differentiellen Dreiecksimpulssignalen und Ausgeben eines zweiten Rechteckwellen-Impulssignals, die zweite Empfangsverbindung umfassend einen zweiten Hysteresekomparator (h2), eine Einschalt-Rücksetzschaltung und ein Ansteuerungselement (d2),
wobei der zweite Hysteresekomparator (h2) mit der zweiten Sekundärspule des Stromverbundtransformators verbunden ist und konfiguriert ist zum Empfangen des zweiten Paars von differentiellen Dreiecksimpulssignalen und, wenn durch die zweite Sekundärspule ausgegebene Spannungswerte von Dreiecksimpulssignalen größer als ein im Voraus bestimmter maximaler Schwellenwert des zweiten Hysteresekomparators sind, ein durch den zweiten Hysteresekomparator ausgegebenes Rechteckwellen-Impulssignal auf einen hohen Pegel eingestellt wird und, wenn durch die zweite Sekundärspule ausgegebene Spannungswerte von Dreiecksimpulssignalen niedriger als ein im Voraus bestimmter minimaler Schwellenwert des zweiten Hysteresekomparators sind, das durch den zweiten Hysteresekomparator ausgegebene Rechteckwellen-Impulssignal von einem hohen Pegel zu einem niedrigen Pegel invertiert wird, wobei die Einschalt-Rücksetzschaltung der zweiten Empfangsverbindung konfiguriert ist zum Einstellen eines anfänglichen Ausgangspegels des durch den zweiten Hysteresekomparator (h2) ausgegebenen Rechteckwellen-Impulssignals,
wobei das erste Rechteckwellen-Impulssignal und das zweite Rechteckwellen-Impulssignal Differenzsignale voneinander sind.

2. Isolierter Treiber nach Anspruch 1, wobei der isolierte Treiber ferner ein Impedanzmodul umfasst und das Impedanzmodul konfiguriert ist zum Reduzieren von Überschwingungssignalen der durch die erste Sekundärspule und die zweite Sekundärspule ausgegebenen Dreieckimpulssignale, wobei die Übertragungsverbindung ein erstes Ausgangsende umfasst, konfiguriert zum Ausgeben eines Rechteckwellen-Impulssignals; der positive Eingang der ersten Primärspule und der positive Eingang der zweiten Primärspule mit dem ersten Ausgangsende der Übertragungsverbindung elektrisch verbunden sind; und der negative Eingang der ersten Primärspule und der negative Eingang der zweiten Primärspule geerdet sind, wobei das Impedanzmodul einen ersten Widerstand (R1) umfasst und der positive Eingang (IP1) der ersten Primärspule und der positive Eingang (IP2) der zweiten Primärspule mit dem ersten Ausgangsende der Übertragungsverbindung unter Verwendung des ersten Widerstands elektrisch verbunden sind.

3. Isolierter Treiber nach Anspruch 2, wobei das Impedanzmodul ferner einen ersten Gleichstrom-Sperrkondensator (C1) umfasst und der erste Widerstand (R1) mit dem Ausgangsende der Übertragungsverbindung unter Verwendung des ersten Gleichstrom-Sperrkondensators elektrisch verbunden ist.

4. Isolierter Treiber nach Anspruch 1, wobei der isolierte Treiber ferner ein Impedanzmodul umfasst und das Impedanzmodul konfiguriert ist zum Reduzieren von Überschwingungssignalen der durch die erste Sekundärspule und die zweite Sekundärspule ausgegebenen Dreieckimpulssignale, wobei die Übertragungsverbindung ein erstes Ausgangsende und ein zweites Ausgangsende umfasst; jedes des ersten Ausgangsendes und des zweiten Ausgangsendes konfiguriert ist zum Ausgeben eines Rechteckwellen-Impulssignals; die durch das erste Ausgangsende und das zweite Ausgangsende ausgegebenen Rechteckwellen-Impulssignale Differenzsignale voneinander sind; der positive Eingang (IP1) der ersten Primärspule und der positive Eingang (IP2) der zweiten Primärspule mit dem ersten Ausgangsende der Übertragungsverbindung elektrisch verbunden sind; und der negative Eingang (IN1) der ersten Primärspule und der negative Eingang (IN2) der zweiten Primärspule mit dem zweiten Ausgangsende der Übertragungsverbindung elektrisch verbunden sind, wobei das Impedanzmodul einen ersten Widerstand (R1) und einen zweiten Widerstand (R2) umfasst; der positive Eingang (IP1) der ersten Primärspule und der positive Eingang (IP2) der zweiten Primärspule mit dem ersten Ausgangsende der Übertragungsverbindung unter Verwendung des ersten Widerstands (R1) elektrisch verbunden sind; und der negative Eingang (IN1) der ersten Primärspule und der negative Eingang (IN2) der zweiten Primärspule mit dem zweiten Ausgangsende der Übertragungsverbindung unter Verwendung des zweiten Widerstands (R2) elektrisch verbunden sind.

5. Isolierter Treiber nach Anspruch 4, wobei das Impedanzmodul ferner einen ersten Gleichstrom-Sperrkondensator (C1) und einen zweiten Gleichstrom-Sperrkondensator (C2) umfasst; der erste Widerstand (R1) mit dem ersten Ausgangsende der Übertragungsverbindung unter Verwendung des ersten Gleichstrom-Sperrkondensators elektrisch verbunden ist; und der zweite Widerstand (R2) mit dem zweiten Ausgangsende der Übertragungsverbindung unter Verwendung des zweiten Gleichstrom-Sperrkondensators elektrisch verbunden ist.

6. Isolierter Treiber nach Anspruch 1, wobei der isolierte Treiber ferner ein Impedanzmodul umfasst und das Impedanzmodul konfiguriert ist zum Reduzieren von Überschwingungssignalen der durch die erste Sekundärspule und die zweite Sekundärspule ausgegebenen Dreieckimpulssignale, wobei die Übertragungsverbindung ein erstes Ausgangsende und ein zweites Ausgangsende umfasst; jedes des ersten Ausgangsendes und des zweiten Ausgangsendes konfiguriert ist zum Ausgeben eines Rechteckwellen-Impulssignals; die durch das erste Ausgangsende und das zweite Ausgangsende ausgegebenen Rechteckwellen-Impulssignale Differenzsignale voneinander sind; der positive Eingang (IP1) der ersten Primärspule und der positive Eingang (IP2) der zweiten Primärspule mit dem ersten Ausgangsende der Übertragungsverbindung elektrisch verbunden sind; und der negative Eingang (IN1) der ersten Primärspule und der negative Eingang (IN2) der zweiten Primärspule mit dem zweiten Ausgangsende der Übertragungsverbindung elektrisch verbunden sind, wobei das Impedanzmodul einen ersten Widerstand (R1) umfasst; ein Ende des ersten Widerstands mit dem ersten Ausgangsende der Übertragungsverbindung, dem positiven Eingang der ersten Primärspule und dem positiven Eingang der zweiten Primärspule elektrisch verbunden ist; und das andere Ende des ersten Widerstands mit dem zweiten Ausgangsende der Übertragungsverbindung, dem negativen Eingang der ersten Primärspule und dem negativen Eingang der zweiten Primärspule elektrisch verbunden ist.

7. Isolierter Treiber nach Anspruch 6, wobei das Impedanzmodul ferner einen ersten Gleichstrom-Sperrkondensator (C1) und einen zweiten Gleichstrom-Sperrkondensator (C2) umfasst; der erste Gleichstrom-Sperrkondensator mit dem ersten Ausgangsende der Übertragungsverbindung und einem Ende des ersten Widerstands (R1) elektrisch verbunden ist; und der zweite Gleichstrom-Sperrkondensator mit dem zweiten Ausgangsende der Übertragungsverbindung und dem anderen Ende des ersten Widerstands elektrisch verbunden ist.

**Revendications**

1. Circuit de commande isolé, comprenant : une liaison d'émission, un transformateur combiné de courant, une première liaison de réception et une seconde liaison de réception, où

   la liaison d'émission est configurée pour délivrer en sortie un signal à impulsions carrées ;
   le transformateur combiné de courant comprend une première bobine primaire, une seconde bobine primaire, une première bobine secondaire et une seconde bobine secondaire, la première bobine primaire comprenant une entrée positive (IP1) et une entrée négative (IN1), la seconde bobine primaire comprenant une entrée positive (IP2) et une entrée négative (IN2), l'entrée positive de la première bobine primaire étant connectée électriquement à l'entrée positive de la seconde bobine primaire, et l'entrée négative de la première bobine primaire étant connectée électriquement à l'entrée négative de la seconde bobine primaire ; le transformateur combiné de courant est configuré pour recevoir le signal à impulsions carrées au moyen de la première bobine primaire et de la seconde bobine primaire, pour générer une première paire de signaux différentiels à impulsions triangulaires par couplage magnétique au moyen de la première bobine secondaire, et pour générer une seconde paire de signaux différentiels à impulsions triangulaires par couplage magnétique au moyen de la seconde bobine secondaire ;
la première liaison de réception est connectée électriquement à la première bobine secondaire et est configurée pour recevoir la première paire de signaux différentiels à impulsions triangulaires et pour délivrer en sortie un premier signal à impulsions carrées, la première liaison de réception comprenant un premier comparateur d'hystérésis (h1), un circuit de réinitialisation de mise sous tension et un élément de commande (d1),
le premier comparateur d'hystérésis (h1) étant connecté à la première bobine secondaire du transformateur combiné de courant et étant configuré pour recevoir la première paire de signaux différentiels à impulsion triangulaires et, lorsque des valeurs de tension de signaux à impulsions triangulaires délivrés en sortie par la première bobine secondaire sont supérieures à un seuil maximum prédéterminé du premier comparateur d'hystérésis, un signal à impulsions carrées délivré en sortie par le premier comparateur d'hystérésis étant réglé à un niveau haut et, lorsque des valeurs de tension de signaux à impulsions triangulaires délivrés en sortie par la première bobine secondaire sont inférieures à un seuil minimum prédéterminé du premier comparateur d'hystérésis, le signal à impulsions carrées délivré en sortie par le premier comparateur d'hystérésis étant inversé, passant d'un niveau haut à un niveau bas,
le circuit de réinitialisation de mise sous tension de la première liaison de réception étant configuré pour définir un niveau de sortie initial du signal à impulsions carrées délivré en sortie par le premier comparateur d'hystérésis (h1) ; et
la seconde liaison de réception est connectée électriquement à la seconde bobine secondaire et est configurée pour recevoir la seconde paire de signaux différentiels à impulsions triangulaires et pour délivrer en sortie un second signal à impulsions carrées, la seconde liaison de réception comprenant un second comparateur d'hystérésis (h2), un circuit de réinitialisation de mise sous tension et un élément de commande (d2),
le second comparateur d'hystérésis (h2) étant connecté à la seconde bobine secondaire du transformateur combiné de courant et étant configuré pour recevoir la seconde paire de signaux différentiels à impulsion triangulaires et, lorsque des valeurs de tension de signaux à impulsions triangulaires délivrés en sortie par la seconde bobine secondaire sont supérieures à un seuil maximum prédéterminé du second comparateur d'hystérésis, un signal à impulsions carrées délivré en sortie par le second comparateur d'hystérésis étant réglé à un niveau haut et, lorsque des valeurs de tension de signaux à impulsions triangulaires délivrés en sortie par la seconde bobine secondaire sont inférieures à un seuil minimum prédéterminé du second comparateur d'hystérésis, le signal à impulsions carrées délivré en sortie par le second comparateur d'hystérésis étant inversé, passant d'un niveau haut à un niveau bas,

le circuit de réinitialisation de mise sous tension de la seconde liaison de réception étant configuré pour définir un niveau de sortie initial du signal à impulsions carrées délivré en sortie par le second comparateur d'hystérésis (h2),

le premier signal à impulsions carrées et le second signal à impulsions carrées étant des signaux différentiels l'un de l'autre.

2. Circuit de commande isolé selon la revendication 1, le circuit de commande isolé comprenant en outre un module d'impédance, le module d'impédance étant configuré pour réduire des signaux de suroscillation des signaux à impulsions triangulaires délivrés en sortie par la première bobine secondaire et la seconde bobine secondaire, la liaison d'émission comprenant une première extrémité de sortie configurée pour délivrer en sortie un signal à impulsions carrées ; l'entrée positive de la première bobine primaire et l'entrée positive de la seconde bobine primaire étant connectées électriquement à la première extrémité de sortie de la liaison d'émission ; et l'entrée négative de la première bobine primaire et l'entrée négative de la seconde bobine primaire étant mises à la terre, le module d'impédance comprenant une première résistance (R1), et l'entrée positive (IP1) de la première bobine primaire et l'entrée positive (IP2) de la seconde bobine primaire étant connectées électriquement à la première extrémité de sortie de la liaison d'émission au moyen de la première résistance.

3. Circuit de commande isolé selon la revendication 2, dans lequel le module d'impédance comprend en outre un premier condensateur de blocage de courant continu (C1), et la première résistance (R1) est connectée électriquement à l'extrémité de sortie de la liaison d'émission au moyen du premier condensateur de blocage de courant continu.

4. Circuit de commande isolé selon la revendication 1, le circuit de commande isolé comprenant en outre un module d'impédance, le module d'impédance étant configuré pour réduire des signaux de suroscillation des signaux à impulsions triangulaires délivrés en sortie par la première bobine secondaire et la seconde bobine secondaire, la liaison d'émission comprenant une première extrémité de sortie et une seconde extrémité de sortie ; la première extrémité de sortie et la seconde extrémité de sortie étant configurées chacune pour délivrer en sortie un signal à impulsions carrées ; les signaux à impulsions carrées délivrées en sortie par la première extrémité de sortie et la seconde extrémité de sortie étant des signaux différentiels l'un de l'autre ; l'entrée positive (IP1) de la première bobine primaire et l'entrée positive (IP2) de la seconde bobine primaire étant connectées électriquement à la première extrémité de sortie de la liaison d'émission ; et l'entrée négative (IN1) de la première bobine primaire et l'entrée négative (IN2) de la seconde bobine primaire étant connectées électriquement à la seconde extrémité de sortie de la liaison d'émission, le module d'impédance comprenant une première résistance (R1) et une seconde résistance (R2) ; l'entrée positive (IP1) de la première bobine primaire et l'entrée positive (IP2) de la seconde bobine primaire étant connectées électriquement à la première extrémité de sortie de la liaison d'émission au moyen de la première résistance (R1) ; et l'entrée négative (IN1) de la première bobine primaire et l'entrée négative (IN2) de la seconde bobine primaire étant connectées électriquement à la seconde extrémité de sortie de la liaison d'émission au moyen de la seconde résistance (R2).

5. Circuit de commande isolé selon la revendication 4, dans lequel le module d'impédance comprend en outre un premier condensateur de blocage de courant continu (C1) et un second condensateur de blocage de courant continu (C2) ; la première résistance (R1) est connectée électriquement à la première extrémité de sortie de la liaison d'émission au moyen du premier condensateur de blocage de courant continu ; et la seconde résistance (R2) est connectée électriquement à la seconde extrémité de sortie de la liaison d'émission au moyen du second condensateur de blocage de courant continu.

6. Circuit de commande isolé selon la revendication 1, le circuit de commande isolé comprenant en outre un module d'impédance, le module d'impédance étant configuré pour réduire des signaux de suroscillation des signaux à impulsions triangulaires délivrés en sortie par la première bobine secondaire et la seconde bobine secondaire, la liaison d'émission comprenant une première extrémité de sortie et une seconde extrémité de sortie ; la première extrémité de sortie et la seconde extrémité de sortie étant configurées chacune pour délivrer en sortie un signal à impulsions carrées ; les signaux à impulsions carrées délivrées en sortie par la première extrémité de sortie et la seconde extrémité de sortie étant des signaux différentiels l'un de l'autre ; l'entrée positive (IP1) de la première bobine primaire et l'entrée positive (IP2) de la seconde bobine primaire étant connectées électriquement à la première extrémité de sortie de la liaison d'émission ; et l'entrée négative (IN1) de la première bobine primaire et l'entrée négative (IN2) de la seconde bobine primaire étant connectées électriquement à la seconde extrémité de sortie de la liaison d'émission, le module d'impédance comprenant une première résistance (R1) ; une extrémité de la première résistance étant connectée électriquement à la première extrémité de sortie de la liaison d'émission, à l'entrée positive de la première bobine primaire et à l'entrée positive de la seconde bobine primaire ; et l'autre extrémité de la première résistance étant connectée électriquement à la seconde extrémité de sortie de la liaison d'émission, à l'entrée négative de la première bobine primaire et à l'entrée négative de la seconde bobine primaire.

7. Circuit de commande isolé selon la revendication 6, dans lequel le module d'impédance comprend en outre un premier condensateur de blocage de courant continu (C1) et un second condensateur de blocage de courant continu (C2) ; le premier condensateur de blocage de courant continu est connecté électriquement à la première extrémité de sortie de la liaison d'émission et à une extrémité de la première résistance (R1) ; et le second condensateur de blocage de courant continu est connecté électriquement à la seconde extrémité de sortie de la liaison d'émission et à l'autre extrémité de la première résistance.

Transmit link 1
(Current limiter)

Pulse shaping
circuit

Receive link 1

Low voltage domain

High voltage domain

Transmit link 2
(Current limiter)

Pulse shaping
circuit

Receive link 2

FIG. 1

Transmit link

IP1

IN1

IP2

IN2

Current synthetic
transformer

First receive link

Second receive link

FIG. 2

FIG. 3

FIG. 4

FIG. 5

FIG. 6

FIG. 7

FIG. 8

FIG. 9

FIG. 10

IP1

First receive link

IN1

IP2

Transmit
link

Second receive link

IN2

Voltage synthetic transformer

FIG. 11

IP1

First receive link

First output
end

IN1

IP2

Transmit link

Second receive link

IN2

FIG. 12

**EP 3 800 771 B1**

FIG. 13

FIG. 14

IP1

First receive link

Transmit link

First output end

IN1

Second output end

IP2

Second receive link

IN2

FIG. 15

IP1

First receive link

Transmit link

First output end

R1

IN1

Second output end

IP2

R2

Impedance module

Second receive link

IN2

FIG. 16

IP1

First

C1          R1

Transmit
link

Second
output
end

IN1

IP2

C2          R2

Impedance
module

IN2

First receive link

Second receive link

FIG. 17

IP1

First
output
end

Transmit
link

Second
output
end

R1

IN1

IP2

Impedance
module

IN2

First receive link

Second receive link

FIG. 18

FIG. 19

FIG. 20

FIG. 21

FIG. 22

**EP 3 800 771 B1**

**REFERENCES CITED IN THE DESCRIPTION**

**Patent documents cited in the description**

- WO 2014059620 A

- US 5514921 A